# EUROPEAN PATENT APPLICATION

(11) **EP 4 794 201 A1**
(43) Date of publication of application: **19.08.2026**
(21) Application number: 26156110.4
(22) Date of filing: 03.02.2026
(51) Int. Cl.: H03M 1/06, H03M 1/12, H03M 1/46

(54) **ANALOG-TO-DIGITAL CONVERTER WITH ANALOG FINITE IMPULSE RESPONSE ANTI ALISAING FILTER**

(30) Priority: 10.02.2025 US 202563756725 P
(71) Applicant: Analog Devices International Unlimited Company, Limerick (IE)
(72) Inventor: KEARNEY, Niall Kevin, Co. Limerick (IE); QUINLAN, Philip P.E., Co. Limerick (IE); JATIN, Jatin, Co. Limerick (IE); BANERJEE, Debopam, Co. Limerick (IE); VANGANURU, Guru Kumar, Co. Limerick (IE)
(74) Representative: Yang, Shu

(57) **Abstract**

The present disclosure relates to interleaved analog-to-digital converters (ADCs) that can provide an analog finite impulse response anti-alias filter. The analog finite impulse response anti-alias filter can have an impulse response duration that is longer than an interleaving time conversion window of an individual interleaved ADC of the interleaved ADC.

## Description

### CROSS REFERENCE TO RELATED APPLICATION

Any and all applications for which a foreign or domestic priority claim is identified in the Application Data Sheet as filed with the present application are hereby incorporated by reference under 37 CFR 1.57. This application claims the benefit of priority of U.S. Provisional Application No. 63/756,725, filed February 10, 2025, and titled "ANALOG-TO-DIGITAL CONVERTER WITH ANALOG FINITE IMPULSE RESPONSE ANTI-ALISAING FILTER," the disclosure of which is hereby incorporated by reference herein in its entirety and for all purposes.

### Technical Field

The disclosed technology relates to analog-to-digital converters. More specifically, embodiments of this disclosure relate to analog-to-digital converters that can provide anti-alias filtering.

### Description of Related Technology

Analog-to-digital converters (ADCs) can convert analog signals to digital signals. ADCs can be implemented in a variety of applications, such as a receiver that processes a radio frequency signal received by an antenna. With a desire for higher performance in receivers and ADCs, there are technical challenges to meeting certain performance specifications.

### SUMMARY OF CERTAIN INVENTIVE ASPECTS

The innovations described in the claims each have several aspects, no single one of which is solely responsible for its desirable attributes. Without limiting the scope of the claims, some prominent features of this disclosure will now be briefly described.

One aspect of this disclosure is an interleaved analog-to-digital converter (ADC) with anti-alias filtering, the interleaved ADC including: a first ADC; and a second ADC interleaved with the first ADC, the interleaved ADC configured to provide an analog finite impulse response anti-alias filter, the analog finite impulse response anti-alias filter having an impulse response duration that is longer than an interleaving time conversion window of the second ADC.

The second ADC can be a successive approximation register (SAR) ADC.

The second ADC can include a main capacitor bank configured to alternatingly and sequentially operate in a sampling phase and a conversion phase, and an additional capacitor bank configured to sample during the conversion phase of the main capacitor bank. The additional capacitor bank can alternate between sampling and performing conversion during conversion phases of the main capacitor bank.

The second ADC can includes a main capacitor bank configured to alternatingly and sequentially operate in a sampling phase and a conversion phase; an odd capacitor bank configured to alternate between sampling and performing conversion during conversion phases of the main capacitor bank; and an even capacitor bank configured to sample concurrent with the odd capacitor bank performing conversion, and to perform conversion concurrent with the odd capacitor bank sampling.

The second ADC can be configured to concurrently sample and perform analog-to-digital conversion.

The first ADC can include any of the features of the second ADC described in the preceding paragraphs. The first ADC and the second ADC can be different instances of the same ADC design.

An impulse response of the analog finite impulse response anti-alias filter can have non-uniform coefficient weights.

An impulse response of second ADC can have non-uniform weights during a sampling phase.

One or more additional ADCs can be interleaved with the first ADC and the second ADC.

A receive system for wireless communication can include an interleaved ADC in accordance with any suitable principles and advantages disclosed herein.

Another aspect of this disclosure is a method of analog-to-digital conversion in an interleaved analog-to-digital converter (ADC), the method including: controlling a main capacitor bank of an ADC of the interleaved ADC to alternatingly and sequentially operate in a sampling phase and a conversion phase; and sequencing an additional capacitor bank of the ADC to alternate between sampling and conversion during conversion phases of the main capacitor bank, wherein the interleaved ADC provides an analog finite impulse response having a duration that is longer than an interleaving time conversion window.

The interleaved ADC can be an interleaved successive approximation register (SAR) ADC.

The method can further include sequencing another capacitor bank of the ADC to alternate between sampling and conversion during conversion phases of the main capacitor bank, wherein the additional capacitor bank and the another capacitor bank sample at different times.

The method can be performed in a receiver of a wireless communication system. The method can be performed in a wireless battery management system.

The method can block a jammer signal using the analog finite impulse response of the interleaved ADC.

The method can further include selecting capacitors to randomize at least one of mismatch or systematically induced sampling errors.

Another aspect of this disclosure is a controller including a processor and storage storing instructions executable by the processor to perform operations, the operations including: controlling a main capacitor bank of an analog-to-digital converter (ADC) to alternatingly and sequentially operate in a sampling phase and a conversion phase; and sequencing an additional capacitor bank of the ADC to alternate between sampling and conversion during conversion phases of the main capacitor bank, such that the ADC has a sampling length that is longer than a conversion time period of the conversion phase of the main capacitor bank.

The operations can further include selecting capacitors to randomize at least one of mismatch or systematically induced sampling errors.

The operations can further include injecting a dither signal during at least one of the sampling phase or the conversion phase.

The operations can further include sequencing another capacitor bank of the ADC to alternate between sampling and conversion during conversion phases of the main capacitor bank, wherein the additional capacitor bank and the another capacitor bank sample during different conversion phases of the main capacitor bank.

### BRIEF DESCRIPTION OF THE DRAWINGS

Embodiments of this disclosure will now be described, by way of non-limiting example, with reference to the accompanying drawings.
Figure 1 is a schematic diagram of an example receive system of a radio frequency (RF) transceiver according to an embodiment.
Figure 2 is a schematic diagram of an example interleaved analog-to-digital converter (ADC) and a controller.
Figure 3 is a schematic diagram of an example successive approximation register (SAR) ADC.
Figure 4 illustrates sampling windows for two ADCs of an interleaved ADC according to an embodiment.
Figures 5A and 5B illustrate non-overlapping impulse responses for two ADCs of an interleaved ADC.
Figures 5C and 5D illustrate impulse responses for individual ADCs of the interleaved ADC of Figure 2 that implement analog anti-alias filtering according to an embodiment.
Figure 6A is a graph with curves for the magnitude of transfer functions for two interleaved ADCs. Figure 6B is graph illustrating a zoomed in portion of the transfer functions of Figure 6A.
Figure 7 is a graph of blocking performance for a receive system.
Figures 8A and 8B show timing of SAR conversion and a sampling phase for the impulse responses of Figures 5B and 5D for one ADC of an interleaved ADC.
Figure 9 is a timing diagram showing the timing of SAR conversion and sampling for different capacitor arrays of a capacitive digital-to-analog converter (C-DAC) of a SAR ADC according to an embodiment.
Figures 10A, 10B, and 10C illustrate capacitor banks of a C-DAC switching array of a SAR ADC according to an embodiment.

### DETAILED DESCRIPTION OF CERTAIN EMBODIMENTS

The following detailed description of certain embodiments and the present various descriptions of specific embodiments. However, the innovations described herein can be embodied in a multitude of different ways, for example, as defined and covered by the claims. It will be understood that elements illustrated in the figures are not necessarily drawn to scale. Moreover, it will be understood that certain embodiments can include more elements than illustrated in a drawing and/or a subset of the illustrated elements. Further, some embodiments can incorporate any suitable combination of features from two or more drawings.

Aspects of this disclosure relate to a new technique whereby an impulse response duration of an analog finite impulse response (FIR) sampling network is engineered to be greater than the duration of an interleaving conversion time window in an analog-to-digital-converter (ADC), such as a successive approximation register (SAR) ADC. This analog FIR can be constructed by dynamically reconfiguring a capacitive digital-to-analog converter (C-DAC) in an interleaved SAR ADC, and augmenting a capacitor array with additional capacitors to facilitate concurrent sampling and conversion to achieve an extended impulse response. This can achieve greater anti-aliasing filtering.

Malicious jammer resilience can be a significant parameter in wireless systems. For example, malicious jammer resilience can be a significant differentiator for a wireless battery management system (WBMS) for electric vehicles (EVs). A radio transceiver's blocking performance can involve a variety of aspects of the lineup, including noise figure, local oscillator phase noise and filtering.

Certain designs encountered challenges meeting blocking specifications. More aggressive analog filter and/or increasing an ADC sampling rate can be implemented to meet such blocking specifications. Reconfiguring the C-DAC in a SAR ADC to incorporate analog FIR anti-aliasing filtering in the sampling phase can be employed in the interleaved ADC configuration in a zero-intermediate frequency (zero-IF) receive architecture. As the radio is enhanced to support higher bandwidth and/or higher data rates while concurrently improving blocking, a significant technical challenge is suppressing the aliased responses of a digital channel select filter below a reciprocal-mixed phase noise limit.

This disclosure provides a technique whereby an impulse response duration of an analog FIR sampling network is engineered to be (1) greater than the duration of the interleaving conversion time window and (2) sample weighting is applied to significantly broaden a sinc filtering null at the effective conversion rate. This can robustly achieve, for example, an additional 16 decibel (dB) suppression of the channel filter alias response and significantly improve blocking performance. Interleaved ADCs of this disclosure can provide improved malicious jammer resilience in a variety of applications, including WBMS.

Some approaches to malicious jammer resilience involve introducing higher order continuous time filtering. This can incur undesirable power consumption and increase die area. Higher order continuous time filtering can also introduce group delay distortion. This can exacerbate undesirable inter symbol interference (ISI) in a radio frequency (RF) transceiver. Another technique is to build-in a passive discrete-time infinite impulse response (IIR) filter into the sampling network. Anti-aliasing techniques of this disclosure can outperform such an approach in terms of attainable attenuation in the band of interest and also preserve linear phase delay.

This disclosure provides technical solutions to challenges associated with increasing signal bandwidth (e.g., 2x greater signal bandwidth) without a corresponding scaling of the ADC sampling rate. The challenge of providing sufficient anti-aliasing filtering is significantly exacerbated under such conditions. Aspects of this disclosure can address the general challenge of increasing normalized signal bandwidth (BW): sampling rate versus anti-alias filtering complexity. Aspects of this disclosure relate to power and area efficient design that can be applied to RF transceivers and in other applications.

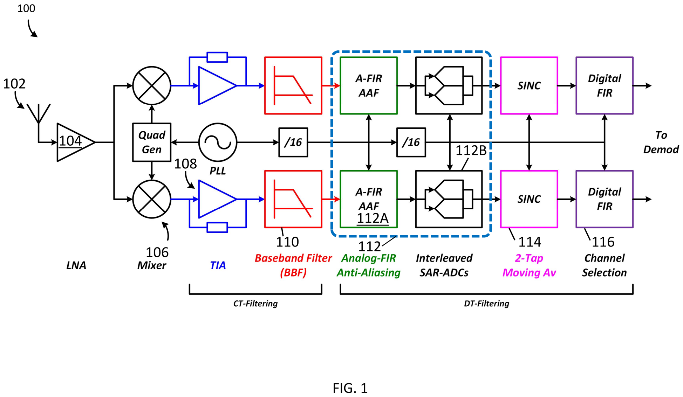

Figure 1 illustrates an example receive system 100 of an RF transceiver according to an embodiment. The receive system can process a RF signal received at an antenna 102. This disclosure provides interleaved ADCs that can provide both analog FIR anti-alias filtering and analog-to-digital conversion. The receive system 100 illustrated in Figure 1 is an example application for such ADCs. The receive system 100 can be implemented in a WBMS. The interleaved ADCs can be SAR ADCs, where a C-DAC is reconfigured during a sampling phase to realize an analog FIR filter. The analog FIR filter can be realized by partitioning the C-DAC array into subunits. The input signal can be sampled onto these individual subunits at a multiple of the ADC conversion rate (i.e., at a higher sampling rate).

In the receive system 100 of Figure 1, the RF signal can be amplified by a low noise amplifier (LNA) 104, down converted by a mixer 106 and provided to an in phase (I) path and a quadrature phase (Q) path. The I path and the Q path can each include continuous time filtering and discrete time filtering. The mixer outputs of the I path and Q path can be amplified by a transimpedance amplifier (TIA) 108 and filtered by a baseband filter (BBF) 110. An output signal from the BBF can be provided to an interleaved ADC 112 that can (1) provide analog FIR anti-alias filtering and (2) analog-to-digital signal conversion. Although an anti-alias filter 112A and an interleaved ADC 112B are shown as two blocks in Figure 1 to illustrate functionality, the interleaved ADC 112 implements the functionality of both of these illustrated blocks. An output signal of the interleaved ADC 112 can be filtered by a sinc filter 114 and a digital FIR 116 and provided to a demodulator.

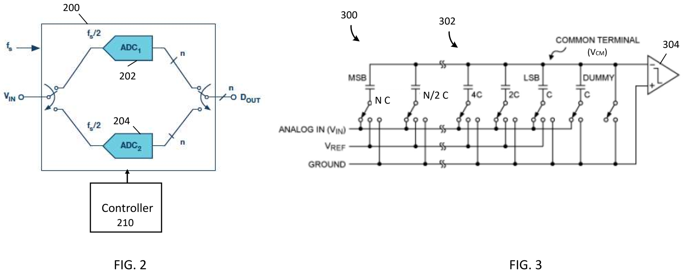

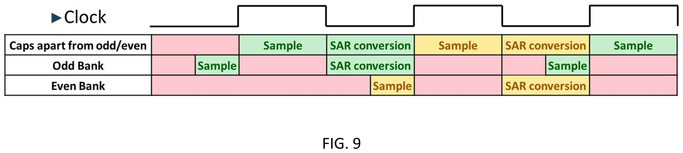

Figure 2 is a schematic diagram of an example interleaved ADC 200 and a controller 210. The interleaved ADC 200 can implement anti-alias filtering disclosed herein. The controller 210 can provide signals to control the interleaved ADC 200. For example, the controller 210 can control capacitor banks of the interleaved ADC 200 to implement functionality described, for example, with reference to Figures 9 to 10C. The controller 210 can include a processor and storage storing instructions executable by the processor implement any suitable functionality to control an ADC disclosed herein. The controller 210 can include a microcontroller or an application specific integrated circuit, for example.

The illustrated interleaved ADC 200 includes two ADCs 202 and 204 that are interleaved in time. Each individual ADC 202 or 204 can be referred to as a channel or a slice. The ADCs 202 and 204 can each be an instance of the same ADC design. The ADCs 202 and 204 are parallel with each other. With time interleaving, the ADCs 202 and 204 can process sample data at a faster rate than the operating sample rate of each individual ADC 202 or 204. Each of the interleaved ADCs 202 and 204 can convert at a rate of f_{S}/2, and the interleaved ADC 200 has an effective conversion rate of f_{S}. The conversion by the ADCs 202 and 204 is data conversion. A first ADC 202 of the interleaved ADC 200 can sample while the second ADC 204 of the interleaved ADC 200 converts. The second ADC 204 can sample while the first ADC 202 converts.

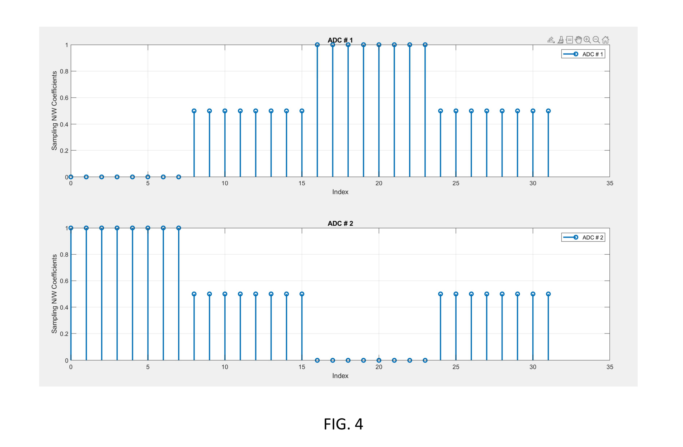

An input voltage V_{IN} can be concurrently provided to both the first ADC 202 and the second ADC 204 so that both of these ADCs can sample concurrently at certain times. For example, when sampling windows for the first ADC 202 and the second ADC 204 overlap as shown in Figure 4, the input voltage can be V_{IN} can be concurrently provided to the first ADC 202 and the second ADC 204.

Any suitable principles and advantages disclosed herein can be implemented in ADCs with two or more interleaved ADCs. In some applications, an ADC in accordance with any suitable principles and advantages disclosed herein can include three or more interleaved ADCs. Each individual ADC of an interleaved ADC with M individual ADCs in parallel can convert at a rate of fs/M, and the interleaved ADC can have an effective conversion rate of fs. The individual ADCs can sample and then convert in a staggered manner, where at each clock cycle at fs one of the M individual ADCs begins sampling.

Figure 3 is a schematic diagram of an example SAR ADC 300. Each of the ADCs 202 and 204 of the interleaved ADC 200 of Figure 2 can be a SAR ADC. The SAR ADC 300 is an example of an ADC that can be used with features of this disclosure to implement anti-alias filtering of this disclosure. The SAR ADC 300 includes a C-DAC 302 and a comparator 304. The C-DAC 302 can include an array of capacitors with binary weighted values plus a dummy capacitor. The C-DAC 302 can have a common terminal connected to an input of the comparator 304. During acquisition, the common terminal of the capacitor array of the C-DAC 302 can be connected to ground and free terminals of the capacitor can be connected to an input voltage V_{IN}. The capacitor array can store charge corresponding to the input voltage V_{IN} after the common terminal is electrically isolated from ground and the free terminals are electrically isolated from the input voltage V_{IN}. The free terminals of the capacitors can then be connected to ground to drive the common terminal negative to a voltage of -V_{IN}. A binary search algorithm can be performed to determine bits associated with the capacitors of the capacitor array from the most significant bit (MSB) to the least significant bit (LSB). The binary search algorithm can include connecting a free terminal of a capacitor with the largest capacitance to a reference voltage V_{REF} starting with the MSB and using the output of the comparator 304 to determine a value of the MSB. The value of the MSB can determine the connection of the capacitor for determining the value of the next most significant bit using the next capacitor with the next highest capacitance. Each bit value can be determined with the binary search algorithm from the MSB to the LSB.

Interleaved ADCs disclosed herein can have an impulse response that is longer than the interleaving conversion window. A sampling duration of the interleaved ADC can be longer than the conversion time. This is counterintuitive.

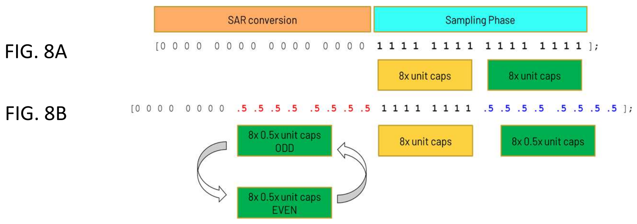

Figure 4 illustrates sampling windows for two ADCs of an interleaved ADC according to an embodiment. The two ADCs can be the ADCs 202 and 204 of Figure 2, for example. The sampling windows of these ADCs overlap. The sampling coefficients have non-uniform weights. The non-uniform weights can have two or more non-zero values. Some sampling coefficients have a weight of 1 and some sampling coefficients have a weight of 0.5 in the example sampling windows shown in Figure 4. Additional unit element capacitors can be included in ADCs for sampling while converting. The number of additional unit element capacitors can correspond to a number of samples that the impulse response is greater than the interleaving conversion window. In an application corresponding to Figure 4, 8 additional unit element capacitors can be included in each individual ADC of an interleaved ADC. Dynamic Element Matching (DEM) can be employed to build resilience against the mismatch within the C-DAC elements as C-DAC elements may be spread over a larger area. A suitable control and switching network for DEM can be deployed. A controller, such as the controller 210 of Figure 2, can implement DEM. Any other suitable technique for randomizing mismatch and/or systematically induced sampling errors can alternatively or additionally be implemented.

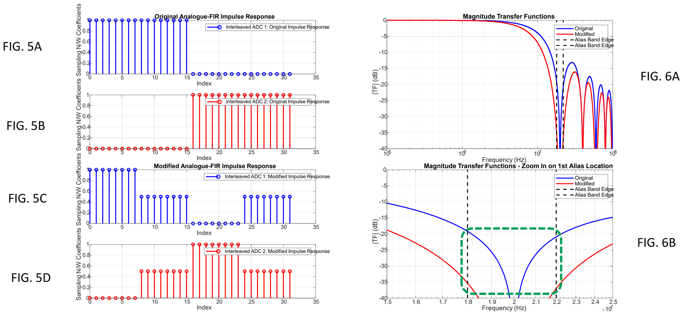

Figures 5A and 5B illustrate impulse responses for two ADCs of an interleaved ADC, where the impulse responses are non-overlapping with each other. These impulse responses also have uniformly weighted coefficients. Figure 5A illustrates an impulse response for a first ADC. Figure 5B illustrates an impulse response for a second ADC, where the first ADC is interleaved with the second ADC.

Figures 5C and 5D illustrate impulse responses for the first ADC 202 and the second ADC 204, respectively, of the interleaved ADC 200 of Figure 2 that implement analog anti-alias filtering in accordance with aspects of this disclosure. These impulse responses overlap with each other and include non-uniform coefficient weighting. For example, the impulse responses of Figures 5C and 5D both have non-zero values for samples 8 to 15 and 24 to 31. In addition, these impulse responses each have more than one coefficient weighting. For instance, the impulse response of Figure 5D has half the coefficient weighting for samples 8 to 15 and 24 to 31 compared to samples 16 to 23. The impulse responses in Figures 5C and 5D are each 24 samples. These impulse responses have a longer duration than the interleaving conversion time window, which is 16 samples in Figures 5C and 5D. The impulse response is 50% longer than the interleaving conversion time window in Figures 5C and 5D. In some other applications, the impulse response can be at least 10%, at least 20%, or at least 25% longer than the interleaving conversion time window. The impulse response can be less than twice as long as or less than 75% longer than the interleaving conversion time window in certain applications.

Figure 6A is a graph with curves for the magnitude of transfer functions for (1) an interleaved ADC with ADCs having the impulse responses of Figures 5A and 5B and (2) an interleaved ADC with ADCs having the impulse responses of Figures 5C and 5D. The alias band edges are also shown in Figure 6A.

Figure 6B is graph illustrating a zoomed in portion of the transfer functions of Figure 6A. Figure 6B provides a zoomed in view of a first alias location that is between the illustrated alias band edges. Figure 6B indicates that an interleaved ADC with ADCs having the impulse responses of Figures 5C and 5D can achieve an enhancement of at least about 16 dB across a 4 megahertz (MHz) signal BW relative to an interleaved ADC with impulse responses of Figures 5A and 5B.

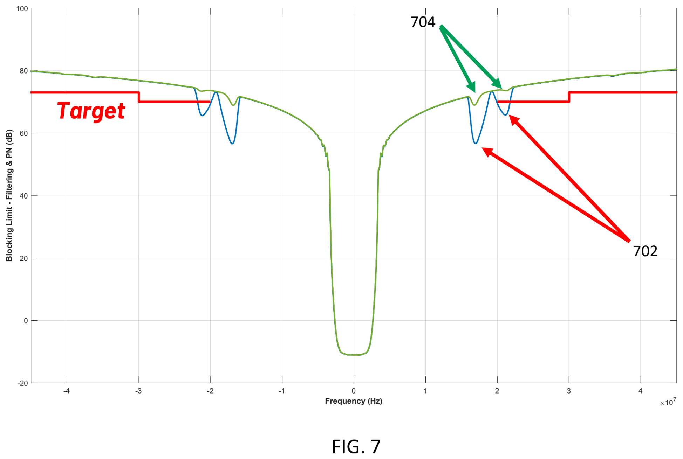

Figure 7 is a graph of blocking performance for a receive system. Certain receive systems encounter blocking degradation. Such blocking degradation can be due to insufficient anti-alias filtering. The blocking degradation can cause the blocking performance to be below a target. In Figure 7, blocking degradation is shown at points 702 of a blocking performance curve. With analog FIR anti-alias filtering disclosed herein, the blocking degradation can be substantially reduced. This can bring the frequency response of the receive system above the target. In Figure 7, substantial reductions in blocking degradation by analog FIR anti-alias filtering disclosed herein are shown at points 704 of a blocking performance curve for an interleaved ADC with analog FIR anti-alias filtering. This illustrates better blocking performance and/or jammer resilience at frequencies around a clock frequency of an interleaved ADC.

Figures 8A and 8B show timing of SAR conversion and a sampling phase for the impulse responses of Figures 5B and 5D for one ADC of an interleaved ADC. The other ADC of an interleaved ADC with 2 interleaved ADCs can operate 180° out of phase with the timing shown in Figures 8A and 8B. Figure 8A shows a sampling phase for the impulse response of Figure 5B. Figure 8B shows a sampling phase for the impulse response of Figure 5D. Figure 5D is an example of an impulse response of an ADC with a duration that is greater than an interleaving conversion time window. The duration of the impulse response in Figure 8B is 24 samples or taps, while the duration of the interleaving time conversion window is 16 samples or taps in the example of Figure 8B. Coefficients of the impulse response are non-uniformly weighted for this impulse response. The coefficients have a lower magnitude in the second part of the SAR conversion and in the second part of the sampling phase (e.g., 0.5 in Figure 8B) relative to in the first part of the sampling phase (e.g., 1 in Figure 8B). These parts of the sampling phase and SAR conversation can be halves, for example, as shown in the example of Figure 8B.

In Figure 8B, a bank of 0.5x unit capacitors of a C-DAC sample while the ADC is in a SAR conversion phase for the impulse response of Figure 5D. In addition, a main bank of capacitors of a C-DAC that are used for alternatingly and sequentially sampling and performing SAR conversion can be used to sample during the sampling phase. The main bank of capacitors can implement different coefficient weights during the sampling phase. For example, during the sampling phase unit capacitors can implement one weight (e.g., 1) during the first part of the sampling phase and 0.5x unit capacitors can implement half of the weight (e.g., 0.5) during a second part of the sampling phase.

Figure 9 is a timing diagram showing the timing of SAR conversion and sampling for different capacitor arrays of a C-DAC of a SAR ADC according to an embodiment. A second ADC of a pair of interleaved ADCs can operate 180° out of phase with the timing shown in Figure 9. The ADC includes a main bank of capacitors, an odd capacitor bank, and an even capacitor bank. The main capacitor bank can alternatingly and sequentially sample during a first phase of the clock signal and perform SAR conversion during a second phase of the clock signal. An additional set of unit capacitors can be divided into two sets of 0.5x unit capacitors. One of the two sets can be referred to as the even capacitor bank. The other of the two sets can be referred to as the odd capacitor bank.

The even capacitor bank and the odd capacitor bank can swap their functionalities every other SAR conversion cycle to facilitate sampling and conversion. During the second phase of the clock signal, the ADC can alternate between (1) the odd capacitor bank performing SAR conversion for the full second phase and the even capacitor bank sampling for the second half of the second phase and (2) the even capacitor bank performing SAR conversion for the full second phase and the odd capacitor bank sampling for the second half of the second phase.

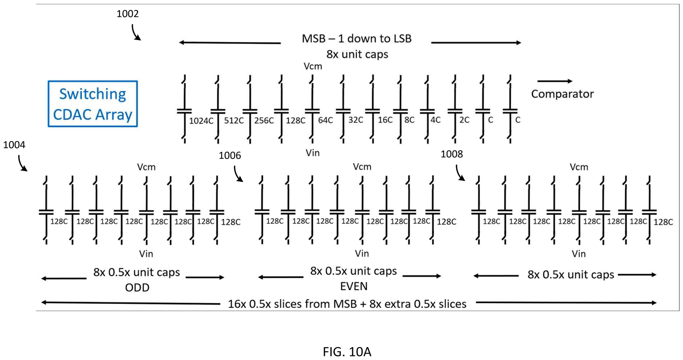

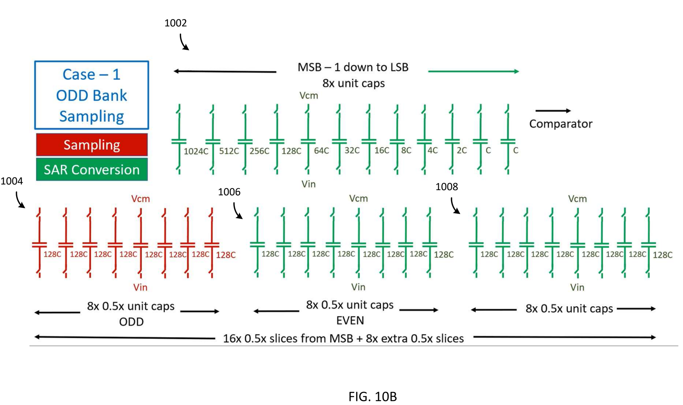

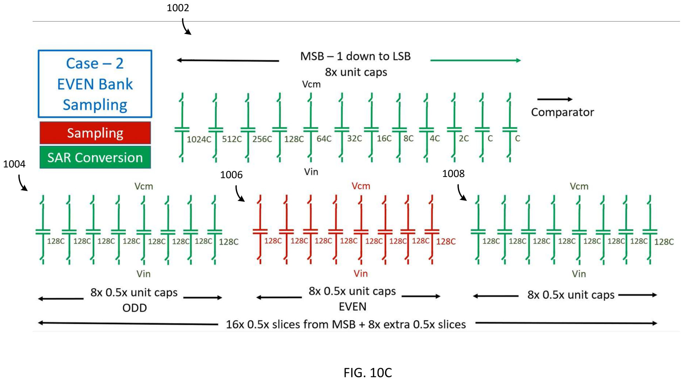

Figures 10A-10C illustrate capacitor banks of a C-DAC switching array of a SAR ADC according to an embodiment. Figure 10A illustrates the capacitor banks of the C-DAC switching array. The capacitors of the capacitor banks are connectable to the common terminal and the input voltage via respective switches. The common terminal is connected to a comparator input. The capacitor banks can together implement a capacitor array for a C-DAC similar to the C-DAC of Figure 3. Figure 10B illustrates which capacitor banks are sampling and performing SAR conversion for odd capacitor bank sampling. Figure 10C illustrates which capacitor banks are sampling and performing SAR conversion for even capacitor bank sampling. In Figures 10A-10C, some switches are omitted to declutter these drawings. The amount of capacitance sampled in each cycle (unit capacitance) can be 256C.

As shown in Figure 10A, the C-DAC switching array can include a main capacitor bank 1002, an odd capacitor bank 1004, an even capacitor bank 1006, and an auxiliary capacitor bank 1008. Referring to Figure 10B, the odd capacitor bank 1004 can be sampling while the other capacitor banks 1002, 1006, and 1008 are performing SAR conversion. This can be for the second part of the second phase of Figure 9. In the first part of the second phase of Figure 9, the capacitor banks 1002, 1006, and 1008 can perform SAR conversion and the odd capacitor bank 1004 can be inactive. Referring to Figure 10C, the even capacitor bank 1006 can be sampling while the other capacitor banks 1002, 1004, and 1008 are performing SAR conversion. This can be for the second part of the second phase of Figure 9 in the next clock SAR conversion cycle relative to Figure 10B. In the first part of the second phase of Figure 9, the capacitor banks 1002, 1004, and 1008 can perform SAR conversion and the even capacitor bank 1006 can be inactive. Figures 10B and 10C correspond to the second phase of the clock signal in Figure 9. The clock can be low during the second phase, for example, as shown in Figure 9. The ADC can alternate between operating in the state of Figure 10B and the state of Figure 10C during the second phase of the clock signal. The auxiliary capacitor bank 1008 together with either the odd capacitor bank 1004 or the even capacitor bank 1006 can implement a capacitor with a capacitance of 2048C for SAR conversion. This can provide an additional binary weighted capacitor for the main capacitor bank 1002.

In the sampling phase of Figure 8B corresponding to the first clock phase of Figure 9, the main capacitor bank 1002 of Figures 10A-10C can implement a coefficient (e.g., 1) for the first part of the sampling phase and the auxiliary capacitor bank 1008 of Figures 10A-10C can implement different non-zero coefficients (e.g., 0.5) of the second part of the sampling phase.

Interleaved ADCs with analog FIR anti-alias filtering of this disclosure can achieve significant advantages. There can be significant additional attenuation at alias band edges. For example, Figure 6B indicates 16 dB additional attenuation at the sampling frequency of the interleaved ADC +/- 2 MHz. The filtering response of the analog FIR anti-alias filters of this disclosure is robust. For example, such a filtering response can be insensitive to process, voltage, and temperature (PVT) variations and no calibration may be needed. The filtering can track the channel filter alias versus channel frequency. A unity gain characteristic can be achieved. A linear phase response can be achieved. Low power consumption can be achieved.

Techniques for SAR ADCs with embedded analog FIR filtering can exploit degrees of freedom from extending impulse response. More sophisticated coefficient weighting and/or engineering of filter response is possible. Differential design can support negatively signed coefficients for the impulse response.

Aspects of this disclosure relate to an interleaved ADC with an analog finite impulse response duration that is greater than an interleaving conversion time window. The interleaved ADC with analog FIR filtering can include one or more additional capacitor arrays augmenting the SAR ADC C-DAC capacitor array. These additional capacitor array(s) can support overlapping sampling windows for contiguous conversion cycles. Such a capacitor array can be arranged to implement non-uniformly weighted coefficients of arbitrary sign. The number of supported coefficients can exceed the number of sampling events within an ADC conversion period.

Aspects of this disclosure relate to a controller for sequencing main a C-DAC and additional capacitor element arrays, reconfiguring during sampling versus conversion phases, and swapping elements between sampling and conversion capacitor arrays to extend the sampling record length beyond the conversion period. Such a controller can be configured to support one or more of capacitor array shuffling, Dynamic Element Matching (DEM), or another suitable element selection algorithm to randomize mismatch and systematically induced sampling errors. In such an arrangement, additional capacitor array elements for usage can be incorporated in conjunction with an algorithm w to randomize mismatch and systematically induced sampling errors. The capacitor arrays and the controller can be arranged to support injection of a dither signal during the sampling and/or conversion process.

In some applications, an analog finite impulse response arrangement can additionally incorporate an infinite impulse response filter.

In the embodiments of this disclosure, circuits, systems and methods are described in connection with particular embodiments. It will be understood, however, that any suitable principles and advantages of the embodiments of this disclosure can be used for any other systems, apparatus, electronic devices, or methods with a need for the technology disclosed herein. Moreover, any suitable principles and advantages disclosed herein can be implemented in systems and in methods that include an interleaved ADC and could benefit from anti-alias filtering and/or malicious jammer resilience. Some example applications include WBMS. The elements and acts of the various embodiments of this disclosure can be combined to provide further embodiments. The acts of the methods discussed herein can be performed in any order as appropriate. Moreover, the acts of the methods discussed herein can be performed serially or in parallel, as appropriate.

The principles and advantages described herein can be implemented in various apparatuses. Examples of such apparatuses can include, but are not limited to, communications systems such as wireless communications systems, consumer electronic products, parts of the consumer electronic products, electronic test equipment, vehicular electronics products such as wireless battery management systems for electric vehicles, industrial electronics products, etc. Further, apparatuses can include unfinished products.

Conditional language used herein, such as, among others, "can," "could," "might," "may," "e.g.," "for example," "such as" and the like, unless specifically stated otherwise, or otherwise understood within the context as used, is generally intended to convey that certain embodiments include, while other embodiments do not include, certain features, elements and/or states. Thus, such conditional language is not generally intended to imply that features, elements and/or states are in any way required for one or more embodiments or whether these features, elements and/or states are included or are to be performed in any particular embodiment.

Unless the context clearly requires otherwise, throughout the disclosure and the claims, the words "comprise," "comprising," "include," "including," and the like are to be construed in an inclusive sense, as opposed to an exclusive or exhaustive sense; that is to say, in the sense of "including, but not limited to." The words "coupled" or connected", as generally used in this disclosure, refer to two or more elements that may be either directly connected, or connected by way of one or more intermediate elements. Additionally, the words "herein," "above," "below," and words of similar import, when used in this application, shall refer to this application as a whole and not to any particular portions of this application.

Where the context permits, words in this disclosure using the singular or plural number may also include the plural or singular number, respectively. The words "or" in reference to a list of two or more items, is intended to cover all of the following interpretations of the word: any of the items in the list, all of the items in the list, and any combination of the items in the list. All numerical values provided herein are intended to include similar values within a measurement error.

While certain embodiments have been described, these embodiments have been presented by way of example only, and are not intended to limit the scope of the disclosure. Indeed, the circuits, systems, and methods of this disclosure may be embodied in a variety of other forms. Furthermore, various omissions, substitutions and changes in the form of the methods, circuits, modules, and systems described herein may be made without departing from the spirit of the disclosure. Such changes and modifications are to be understood as being included within the scope of the disclosure. For example, while blocks are presented in a given arrangement, alternative embodiments may perform similar functionalities with different components and/or circuit topologies, and some blocks may be deleted, moved, added, subdivided, combined, and/or modified. Each of these blocks may be implemented in a variety of different ways. Any suitable combination of the elements and acts of the various embodiments described herein can be combined to provide further embodiments. The various features and processes described above may be implemented independently of one another or may be combined in various ways. All possible combinations and sub-combinations of features of this disclosure are intended to fall within the scope of this disclosure.

### Numbered aspects

By way of non-limiting example, some aspects of the disclosure are set out in the following numbered clauses.
Numbered Clause 1. An interleaved analog-to-digital converter (ADC) with anti-alias filtering, the interleaved ADC comprising:
   a first ADC; and
   a second ADC interleaved with the first ADC, wherein the interleaved ADC is configured to provide an analog finite impulse response anti-alias filter, the analog finite impulse response anti-alias filter having an impulse response duration that is longer than an interleaving time conversion window of the second ADC.
Numbered Clause 2. The interleaved ADC of Numbered Clause 1, wherein the second ADC is a successive approximation register (SAR) ADC.
Numbered Clause 3. The interleaved ADC of Numbered Clause 1 or 2, wherein the second ADC comprises:
   a main capacitor bank configured to alternatingly and sequentially operate in a sampling phase and a conversion phase; and
   an additional capacitor bank configured to sample during the conversion phase of the main capacitor bank.
Numbered Clause 4. The interleaved ADC of Numbered Clause 3, wherein the additional capacitor bank is configured to alternate between sampling and performing conversion during conversion phases of the main capacitor bank.
Numbered Clause 5. The interleaved ADC of any preceding Numbered Clause, wherein the second ADC comprises:
   a main capacitor bank configured to alternatingly and sequentially operate in a sampling phase and a conversion phase;
   an odd capacitor bank configured to alternate between sampling and performing conversion during conversion phases of the main capacitor bank; and
   an even capacitor bank configured to sample concurrent with the odd capacitor bank performing conversion, and to perform conversion concurrent with the odd capacitor bank sampling.
Numbered Clause 6. The interleaved ADC of any preceding Numbered Clause, wherein the second ADC is configured to concurrently sample and perform analog-to-digital conversion.
Numbered Clause 7. The interleaved ADC of any preceding Numbered Clause, wherein an impulse response of the analog finite impulse response anti-alias filter has non-uniform coefficient weights.
Numbered Clause 8. The interleaved ADC of any preceding Numbered Clause, wherein an impulse response of second ADC has non-uniform weights during a sampling phase.
Numbered Clause 9. The interleaved ADC of any preceding Numbered Clause, further comprising one or more additional ADCs interleaved with the first ADC and the second ADC.
Numbered Clause 10. A receive system for wireless communication, the receive system comprising the interleaved ADC of any preceding Numbered Clause.
Numbered Clause 11. A method of analog-to-digital conversion in an interleaved analog-to-digital converter (ADC), the method comprising:
   controlling a main capacitor bank of an ADC of the interleaved ADC to alternatingly and sequentially operate in a sampling phase and a conversion phase; and
   sequencing an additional capacitor bank of the ADC to alternate between sampling and conversion during conversion phases of the main capacitor bank, wherein the interleaved ADC provides an analog finite impulse response having a duration that is longer than an interleaving time conversion window.
Numbered Clause 12. The method of Numbered Clause 11, wherein the interleaved ADC is an interleaved successive approximation register (SAR) ADC.
Numbered Clause 13. The method of Numbered Clause 11 or 12, further comprising sequencing another capacitor bank of the ADC to alternate between sampling and conversion during conversion phases of the main capacitor bank, wherein the additional capacitor bank and the another capacitor bank sample at different times.
Numbered Clause 14. The method of any of Numbered Clauses 11 to 13, wherein the method is performed in a wireless battery management system.
Numbered Clause 15. The method of any of Numbered Clauses 11 to 14, wherein the method blocks a jammer signal using the analog finite impulse response of the interleaved ADC.
Numbered Clause 16. The method of any of Numbered Clauses 11 to 15, further comprising selecting capacitors to randomize at least one of mismatch or systematically induced sampling errors.
Numbered Clause 17. A controller comprising a processor and storage storing instructions executable by the processor to perform operations, the operations comprising:
   controlling a main capacitor bank of an analog-to-digital converter (ADC) to alternatingly and sequentially operate in a sampling phase and a conversion phase; and
   sequencing an additional capacitor bank of the ADC to alternate between sampling and conversion during conversion phases of the main capacitor bank, such that the ADC has a sampling length that is longer than a conversion time period of the conversion phase of the main capacitor bank.
Numbered Clause 18. The controller of Numbered Clause 17, wherein the operations further comprise selecting capacitors to randomize at least one of mismatch or systematically induced sampling errors.
Numbered Clause 19. The controller of Numbered Clause 17 or 18, wherein the operations further comprise injecting a dither signal during at least one of the sampling phase or the conversion phase.
Numbered Clause 20. The controller of any of Numbered Clauses 17 to 19, wherein the operations further comprise sequencing another capacitor bank of the ADC to alternate between sampling and conversion during conversion phases of the main capacitor bank, wherein the additional capacitor bank and the another capacitor bank sample during different conversion phases of the main capacitor bank.

## Claims

1. An interleaved analog-to-digital converter (ADC) with anti-alias filtering, the interleaved ADC comprising:
a first ADC; and
a second ADC interleaved with the first ADC, wherein the interleaved ADC is configured to provide an analog finite impulse response anti-alias filter, the analog finite impulse response anti-alias filter having an impulse response duration that is longer than an interleaving time conversion window of the second ADC.

2. The interleaved ADC of Claim 1, wherein the second ADC is a successive approximation register (SAR) ADC.

3. The interleaved ADC of Claim 1 or 2, wherein the second ADC comprises:
a main capacitor bank configured to alternatingly and sequentially operate in a sampling phase and a conversion phase; and
an additional capacitor bank configured to sample during the conversion phase of the main capacitor bank, preferably wherein the additional capacitor bank is configured to alternate between sampling and performing conversion during conversion phases of the main capacitor bank.

4. The interleaved ADC of any preceding Claim, wherein the second ADC comprises:
a main capacitor bank configured to alternatingly and sequentially operate in a sampling phase and a conversion phase;
an odd capacitor bank configured to alternate between sampling and performing conversion during conversion phases of the main capacitor bank; and
an even capacitor bank configured to sample concurrent with the odd capacitor bank performing conversion, and to perform conversion concurrent with the odd capacitor bank sampling.

5. The interleaved ADC of any preceding Claim, wherein the second ADC is configured to concurrently sample and perform analog-to-digital conversion.

6. The interleaved ADC of any preceding Claim, wherein an impulse response of the analog finite impulse response anti-alias filter has non-uniform coefficient weights and/or wherein an impulse response of second ADC has non-uniform weights during a sampling phase.

7. The interleaved ADC of any preceding Claim, further comprising one or more additional ADCs interleaved with the first ADC and the second ADC.

8. A receive system for wireless communication, the receive system comprising the interleaved ADC of any preceding Claim.

9. A method of analog-to-digital conversion in an interleaved analog-to-digital converter (ADC), the method comprising:
controlling a main capacitor bank of an ADC of the interleaved ADC to alternatingly and sequentially operate in a sampling phase and a conversion phase; and
sequencing an additional capacitor bank of the ADC to alternate between sampling and conversion during conversion phases of the main capacitor bank, wherein the interleaved ADC provides an analog finite impulse response having a duration that is longer than an interleaving time conversion window.

10. The method of Claim 9, wherein the interleaved ADC is an interleaved successive approximation register (SAR) ADC.

11. The method of Claim 9 or 10, further comprising one or more of the following:
sequencing another capacitor bank of the ADC to alternate between sampling and conversion during conversion phases of the main capacitor bank, wherein the additional capacitor bank and the another capacitor bank sample at different times;
selecting capacitors to randomize at least one of mismatch or systematically induced sampling errors.

12. The method of any of Claims 9 to 11, wherein the method is performed in a wireless battery management system.

13. The method of any of Claims 9 to 12, wherein the method blocks a jammer signal using the analog finite impulse response of the interleaved ADC.

14. A controller comprising a processor and storage storing instructions executable by the processor to perform operations, the operations comprising:
controlling a main capacitor bank of an analog-to-digital converter (ADC) to alternatingly and sequentially operate in a sampling phase and a conversion phase; and
sequencing an additional capacitor bank of the ADC to alternate between sampling and conversion during conversion phases of the main capacitor bank, such that the ADC has a sampling length that is longer than a conversion time period of the conversion phase of the main capacitor bank.

15. The controller of Claim 14, wherein the operations further comprise one or more of the following:
selecting capacitors to randomize at least one of mismatch or systematically induced sampling errors;
injecting a dither signal during at least one of the sampling phase or the conversion phase;
sequencing another capacitor bank of the ADC to alternate between sampling and conversion during conversion phases of the main capacitor bank, wherein the additional capacitor bank and the another capacitor bank sample during different conversion phases of the main capacitor bank.
